# EUROPÄISCHE PATENTSCHRIFT

(11) **EP 2 992 342 B1**
(45) Veröffentlichungstag und Bekanntmachung des Hinweises auf die Patenterteilung: **14.06.2017**
(21) Anmeldenummer: 14718990.6
(22) Anmeldetag: 23.04.2014
(51) Int. Cl.: G01R 33/09, G01R 33/00

(54) **MAGNETFELDSENSORVORRICHTUNG**
MAGNETIC FIELD SENSOR DEVICE
DISPOSITIF DÉTECTEUR DE CHAMP MAGNÉTIQUE

(30) Priorität: 02.05.2013 DE 102013104486
(43) Veröffentlichungstag der Anmeldung: 09.03.2016
(73) Patentinhaber: Sensitec GmbH, 35633 Lahnau (DE)
(72) Erfinder: GRIMM, Hubert, 55278 Mommenheim (DE); SPETTER, Viktor, 55546 Pfaffen-Schwabenheim (DE)
(74) Vertreter: Spachmann, Holger
(86) Internationale Anmeldenummer: PCT/EP2014/058220
(87) Internationale Veröffentlichungsnummer: WO 2014/177436

(56) Entgegenhaltungen:
- WO-A1-2012/103950
- DE-A1- 4 319 146
- US-B1- 6 822 443

## Beschreibung

Die Erfindung betrifft eine Magnetfeldsensorvorrichtung zur Messung zumindest einer Magnetfeldvektorkomponente, die zumindest eine auf einem Chipsubstrat angeordnete anisotrope magnetoresistive Widerstandseinrichtung umfasst. Die Widerstandseinrichtung umfasst eine Mehrzahl von magnetoresistiven AMR-Widerstandselementen, die durch elektrische Leitungsstreifen in Reihe kontaktiert sind.

### STAND DER TECHNIK

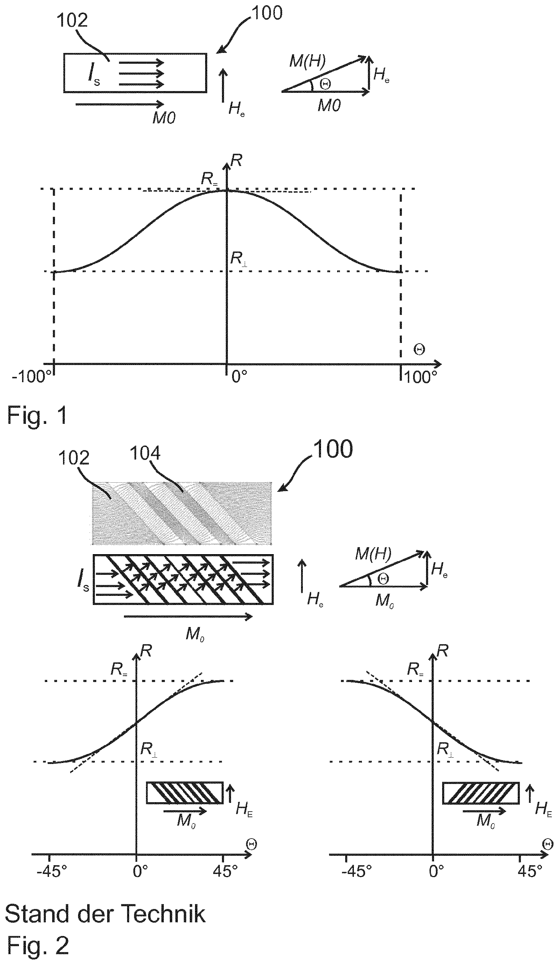

Elektronische Magnetfeldsensorvorrichtungen, die auf der Wirkungsweise von AMR-Widerstandsschichten beruhen, sind aus dem Stand der Technik hinlänglich bekannt. Der AMR-Effekt (anisotrope magnetoresistive Effekt) ist die Eigenschaft eines Materials, ihren elektrischen Widerstand in Abhängigkeit eines Winkels zwischen einem elektrischen Strom, der durch das Material fließt, und einem externen Magnetfeld entsprechend der Lage des Magnetfeldvektors zum Stromfluss durch das Material zu ändern. Dieser Effekt kann insbesondere bei sehr langen, dünnen und schmalen Streifen von Permalloy beobachtet werden. Permalloy ist eine Legierung, die aus 81 % Nickel und 19 % Eisen besteht. Der elektrische Widerstand dieses Materials ist am größten, wenn der elektrische Strom in Richtung einer Magnetfeldvektorkomponente fließt. Er ist am geringsten, wenn der elektrische Strom rechtwinklig zur elektrischen Magnetfeldvektorkomponente ausgerichtet ist. Auf molekularer Ebene wird dieser Effekt durch eine Störung der Elektronenspinausrichtung der Atome verursacht, die von der elektrischen Magnetisierungsrichtung abhängt. Im Allgemeinen wird bei der oben genannten Konfiguration der elektrische Widerstand bestimmt durch *R* = *R*_{⊥}+ (*R*₌ - *R*_{⊥})cos²(Θ) mit θ als Winkel zwischen der Magnetfeldvektorkomponente und der Stromflussrichtung in dem AMR-Messstreifen. Wie aus der vorgenannten Gleichung zu sehen ist, ist eine hohe Sensitivität, d.h. eine starke Widerstandsänderung bei Veränderung des zu messenden Magnetfelds dann besonders groß, wenn der Strom in etwa 45° zur Magnetfeldvektorkomponente fließt. Bei dieser Winkelbeziehung von Strom und Vektorkomponente ergibt sich eine Linearisierung der Widerstandsänderung in Bezug auf eine Magnetfeldänderung. In der Fig. 1 ist der obige formelmäßige Zusammenhang zwischen dem Messstrom *I*_{S} und einem die Widerstandsänderung hervorrufendes Magnetfeld *M(H)* dargestellt. Dabei wird das die Widerstandsänderung bewirkende Magnetfeld *M(H)* durch eine Vormagnetisierung *M*₀ in Richtung des Stromflusses *I*_{S} und eine dazu rechtwinklige Vektorkomponente *H*ₑ, die durch das externe, zu messende Magnetfeld bereitgestellt wird, symbolisiert.

Aus dem Stand der Technik ist zum Design von Magnetfeldsensorvorrichtungen bekannt, sogenannte Barberpolestrukturen, d.h. dünne leitfähige Strukturen auf einem AMR-Messstreifen anzuordnen, die aus extrem leitfähigem Material wie beispielsweise Aluminium, Kupfer, Gold oder Silber bestehen. Die Barberpolestrukturen sind um 45° gegenüber der Längserstreckung des AMR-Widerstandsstreifen ausgerichtet und erinnern an ein Werbezeichen für einen Frisörbetrieb in den USA, daher die Bezeichnung Barberpolestruktur. Ein durch den Widerstandsstreifen fließender Strom wird dabei in eine 45°-Richtung zur Längserstreckung des Streifens gezwungen, so wie es in Fig. 2 dargestellt ist. Hierdurch wird die in Fig. 1 dargestellte Abhängigkeitskurve des Widerstands von Ausrichtung des Stromvektors zum Magnetfeldvektor um 45° verschoben, so dass sie, wie in Fig. 2 dargestellt, in einen linearisierten Bereich überführt werden kann. Abhängig von der Ausrichtung der Barberpolestrukturen ergibt sich eine positive bzw. negative Flanke einer Linearisierung zwischen Widerstand und Größe des zu messenden Magnetfelds, sofern das externe Magnetfeld längs oder quer zur Erstreckung des AMR-Widerstandsstreifens ausgerichtet ist.

Magnetfeldsensorvorrichtungen, die auf Barberpolestrukturen beruhen, sind beispielsweise in der DE 344 22 78 A1 bekannt. Hierbei sind vier derartige Magnetfeldsensorvorrichtungen mit unterschiedlich ausgerichteten Barberpolestrukturen in einer Wheatstone-Messbrücke zusammengeschaltet, wobei durch ein externes Magnetfeld, das von einer makroskopischen Magnetspule erzeugt wird, eine Vormagnetisierung der inneren Magnetisierung *M*₀ der Widerstandsstreifen hergestellt wird, um eine linearisierte Widerstandsabhängigkeit von dem externen Magnetfeld *H*ₑ hervorzurufen. Hierzu wird ein Magnetfeld senkrecht oder parallel zum Stromfluss erzeugt, dass eine Vormagnetisierung der AMR-Widerstandsmessstreifen bewirkt, so dass ein dazu rechtwinklig ausgerichtetes zu messendes Magnetfeld *H*ₑ eine lineare Veränderung des elektrischen Widerstands der Magnetfeldsensorvorrichtung erzeugt, die messbar ist, und aus der auf die Größe des externen Magnetfeldes *H*ₑ zurückgeschlossen werden kann.

Eine Verbesserung eines derartigen Designs ist beispielsweise in der DE 43 191 46 C2 beschrieben. Diese schlägt vor, eine Reihe von AMR-Widerstandseinrichtungen mit Barberpolestrukturen entlang eines von einem Flipstrom durchflossenen Leiters anzuordnen, wobei der Flipstromleiter eine Vormagnetisierung *M*₀ in Längsrichtung der AMR-Messstreifen bewirkt. Durch ein Flippen, d.h. eine Umkehrung der inneren Magnetisierung, kann eine Neuausrichtung bzw. Kalibrierung des Widerstandsverhaltens erreicht werden. Ein hierzu rechtwinklig ausgerichtetes externes Magnetfeld *H*ₑ kann mit hoher Sensitivität gemessen werden. Zur Erzeugung einer Vormagnetisierung *M*₀ in Längsrichtung der AMR-Widerstandsstreifen wird ein Flipstrom *I*_{f}, der durch einen Flipleiter fließt, verwendet, so dass ein erhöhter Stromverbrauch für die Bereitstellung einer Vormagnetisierung aufgewendet werden muss. Das Aufbringen der Barberpolestrukturen hat prozesstechnische Nachteile, wobei sehr feine Mikrostrukturen auf den AMR-Widerstandsstreifen angeordnet werden müssen, und Kurzschlüsse zwischen den einzelnen Streifen vermieden werden müssen. Die Anordnung des Flipleiters erhöht die Anzahl der Fertigungsschritte, und die Steuerung des Flipstroms erhöht die Anforderungen an eine Steuerelektronik.

Das Verhältnis von R_{⊥} zu R- liegt bei Permalloy im Bereich von etwa 3 %. Aufgrund der Formanisotropie stellt sich beim magnetoresistiven Widerständen, bei denen Streifen besonders dünn ausgeformt sind, und die Länge groß gegenüber der Breite gewählt ist, eine bevorzugte Magnetisierungsrichtung aufgrund der Formanisotropie in Längsrichtung also parallel zur Stromflussrichtung ein. Zur Einprägung einer Vormagnetisierung und zur Stabilisierung einer Magnetisierung in einem Widerstandsstreifen ist es bekannt, zusätzliche makroskopische Permanentmagnete vorzusehen, die in der Nähe der magnetoresistiven Schichtstruktur montiert sind. Diese Permanentmagnete sollen ein Umklappen der inneren Magnetisierung der Streifen verhindern. Derartige zusätzliche Permanentmagnete sind z.B. in der DE 42 21 385 C2 beschrieben. Nachteilig bei dieser Lösung ist insbesondere der hohe Montageaufwand sowie die resultierende Baugröße und die Kosten der eingesetzten Komponenten.

Die EP 0 766 830 B beschreibt einen magnetoresistiven Lesekopf für ein digitales Magnetspeichermedium. In der EP 0 585 008 A2 wird ein weiterer magnetoresistiver Lesekopf für ein digitales Magnetspeichermedium, z.B. für eine Festplattenanwendung vorgestellt, der zwei Permanentmagnetelemente aufweist, zwischen denen ein einzelnes magnetoresistives Widerstandselement angeordnet ist. Die beiden Permanentmagnetelemente stellen in dem Widerstandselement eine interne Magnetisierungsrichtung ein. Das Widerstandselement ist durch elektrische Leitungsstreifen derart kontaktiert, so dass ein Messstrom ca. 45° versetzt gegenüber der Magnetisierungsrichtung durch das Widerstandselement fließen kann. Diese Konfiguration ist gewählt, so dass eine bitinformationstragende Magnetisierungsstelle eines ferromagnetischen Magnetspeichermediums, z.B. eines Magnetbandes oder einer Magnetspeicherplatte im Widerstandselement eine definiert rechteckförmige und symmetrische Widerstandsänderung mit steilen Flanken und geringer räumlicher/zeitlicher Auflösung hervorruft, so dass eine Magnetbitspeicherdichte erhöht, Übersprechen benachbarter Magnetfeldbits unterdrückt und analoge Servodaten symmetrisch ausgelesen werden können. Der Lesekopf ist optimiert, binäre Magnetfeldinformationen in ähnlicher räumlicher Ausdehnung wie das Widerstandselement selbst in hoher Geschwindigkeit zu erfassen und ist ungeeignet, eine Stärke und Richtung einer Magnetfeldkomponente eines externen Magnetfeldes z.B. für eine Kompass- oder Strommessanwendung zu erfassen.

Daher ergibt sich aus den vorbekannten AMR-Magnetfeldsensorvorrichtungen das Problem, dass durch die Verwendung von Barberpolestreifen zur Linearisierung der Widerstandskennlinie zum einen prozesstechnisch filigrane Barberpolestrukturen auf den Widerstandsstreifen angeordnet werden müssen, zum anderen eine externe Beschaltung und ein zusätzlicher Flipleiter oder externe Magnete zur Vormagnetisierung bzw. zur Aufrechthaltung der inneren Magnetisierung vorgesehen werden muss, die den Stromverbrauch heraufsetzen und die Komplexität der elektronischen Schaltung erhöhen.

Die US 6,822,443 B1 zeigt eine Magnetfeldsensorvorrichtung zur Messung zweier, gegeneinander abgewinkelter Magnetfeldkomponenten. Die Magnetfeldsensorvorrichtung umfasst zwei Wheatstone-Messbrücken, die getrennt voneinander auswertbar sind. Jede Messbrücke umfasst zwei magnetisch neutrale Widerstände und zwei magnetoresistive Widerstände. Die magnetoresistiven Widerstände können AMR/SDT/GMR oder Hall-Widerstände sein. Zur Erhöhung der Magnetfeldempfindlichkeit können Flusskonzentrationselemente im Bereich der magnetoresistiven Widerstände angeordnet sein, die aus NiFe bestehen und unmagnetisiert sind und als "free ferromagnetic layer" bezeichnet werden.

In der WO 2012/103950 A1 wird eine AMR-Widerstandseinrichtung vorgestellt, deren Brückenwiderstände aus einer Reihenschaltung von einzelnen Widerstandselementen besteht, wobei die Anordnung der Widerstandselemente eines Brückenwiderstands interdigital in die Anordnung von Widerstandselemente eines zweiten Brückenwiderstands eingreift.

Ausgehend von dem oben dargestellten Stand der Technik ist es Aufgabe der Erfindung, eine AMR-Magnetfeldsensorvorrichtung vorzugschlagen, bei der eine hochsensitive linearisierte Widerstandskennlinie erreicht werden kann, ohne die Nachteile von externen makroskopischen Stützmagneten, Barberpolestrukturen und eines Flipstromleiters in Kauf nehmen zu müssen, so dass eine preisgünstige Magnetfeldsensorvorrichtung erreicht werden kann.

### OFFENBARUNG DER ERFINDUNG

Gelöst wird die oben genannte Aufgabe durch eine Magnetfeldsensorvorrichtung nach der Lehre des Anspruchs 1. Vorteilhafte Ausführungsformen der Erfindung sind Gegenstand der abhängigen Ansprüche.

Erfindungsgemäß umfasst die Magnetfeldsensorvorrichtung zur Messung einer Magnetfeldvektorkomponente *H*ₑ zumindest eine auf einem Chipsubstrat angeordnete anisotrope magnetoresistive Widerstandseinrichtung (AMR-Widerstandseinrichtung), wobei die Widerstandseinrichtung eine Mehrzahl von magnetoresistiven AMR-Widerstandselementen umfasst, die durch elektrische Leitungsstreifen kontaktiert sind. Jedem Widerstandselement ist zumindest ein permanentmagnetisches Magnetisierungselement mit einer Magnetisierungsachse derart zugeordnet, so dass das Widerstandselement von einem Vormagnetisierungsfeld *H*₀ des Magnetisierungselements in Richtung der Magnetisierungsachse durchsetzt wird. Die Erfindung beruht darauf, dass ein durch das Widerstandselement fließender Messstrom *I*_{S} von einem Kontaktbereich zwischen einem ersten Leitungsstreifen und dem Widerstandselement zu einem Kontaktbereich zwischen dem Widerstandselement und einem zweiten Leitungsstreifen eine mittlere Stromrichtungsachse aufweist, die in einem vordefinierten Linearisierungswinkel α>0° und α<90° zur Magnetisierungsachse steht.

Mit anderen Worten wird eine Magnetfeldsensorvorrichtung vorgeschlagen, die zumindest eine, insbesondere mehrere Widerstandseinrichtungen, d.h. separat anschließbare AMR-Widerstände aufweist, wobei jede Widerstandseinrichtung eine Mehrzahl von elektrisch in Reihe geschalteten AMR-Widerstandselementen umfasst. Die Widerstandselemente sind durch elektrische Leitungsstreifen derart kontaktiert, dass ein Strom in Reihe durch die AMR-Widerstandselemente fließen kann, wobei jedem Widerstandselement ein oder zwei Magnetisierungselemente zugeordnet sind, die durch ihr Vormagnetisisierungsfeld *H*₀ eine innere Vormagnetisierung *M*₀ innerhalb des Widerstandselements bewirken. Die Zuordnung des Magnetisierungselements zur Stromflussrichtung, die durch die Ausrichtung und Form der Leitungsstreifen und ihrer Kontaktierung mit dem Widerstandselement vorgegeben ist, ist derart gewählt, dass ein Linearisierungswinkel α zwischen Magnetisierungsachse des Magnetisierungselements und der Stromrichtung des Messstroms entsteht, die zwischen 0° und 90° einstellbar ist. Hierdurch wird, wie vergleichsweise in den Widerstandskennlinien in Fig. 2 dargestellt, eine Verschiebung der Widerstandskennlinie in Richtung eines linearen Bereichs α=45° zwischen Magnetisierungsvektor und Stromflussrichtung einstellbar, so dass eine linearisierte Kennlinie des Widerstands in Abhängigkeit eines externen Magnetfelds *H*ₑ erreicht werden kann. Der Strom durch das Widerstandselement kann abgewinkelt gegenüber dem Strom durch die Leitungselemente fließen, wobei der Magnetisierungsvektor parallel oder senkrecht zur Stromflussrichtung durch die Leitungselemente ausgerichtet sein kann. Alternativ kann die Stromflussrichtung durch die Leitungselemente und das Widerstandselement identisch sein, aber der Magnetisierungsvektor in einem Winkel α gegenüber der Gesamtstromrichtung ausgerichtet sein.

Es kann beispielsweise ein einzelnes Magnetisierungselement für eine Mehrzahl von Widerstandselementen eine Vormagnetisierung *M*₀ bereitstellen, jedoch kann bevorzugt jedem Widerstandselement ein separates Magnetisierungselement bzw. ein Paar von zwei gleichsinnig orientierte Magnetisierungselemente zugeordnet sein. Durch die Lage der Kontaktierung des Widerstandselements mit den Leitungsstreifen - d.h. Form der AMR-Widerstandselemente und Lage der Kontaktstellen zwischen Leitungsstreifen und Widerstandselement - kann die Richtung des Stromverlaufs innerhalb des Widerstandselements eingestellt werden. Diese kann bevorzugt nicht parallel und nicht senkrecht zur Ausrichtung der Reihe von AMR-Widerstandselementen eingestellt sein. Die Lage eines Magnetisierungselements mit Magnetisierung in Richtung der Längs- oder Querausrichtung der Widerstandselemente definiert bezüglich der Stromflussrichtung durch die Widerstandselemente den Linearisierungswinkel α. Durch die strukturelle Anordnung der Magnetisierungselemente in Bezug auf die Stromflussrichtung durch die AMR-Widerstandselemente wird eine Verschiebung der Widerstandskennlinie derart erreicht, dass eine Linearisierung des Widerstands in Abhängigkeit des magnetischen Feldes bereitgestellt wird. Die Anordnung von Barberpolestreifen und das künstliche Erzeugen eines Flipmagnetfelds bzw. Vormagnetisierungsmagnetfelds mit einem Flipleiter entfallen, wobei eine homogene Führung des Magnetfeldes des Permanentmagnetelements durch das Widerstandselement erzielt werden kann. Das Sensorchipdesign ist herstellungstechnisch einfach zu realisieren, benötigt weniger elektrische Anschlüsse und eine einfach gestaltete Ansteuerelektronik. Der Stromverbrauch ist gesenkt.

Grundsätzlich kann der Liniearisierungswinkel einen beliebigen Wert zwischen 0° bis 90° einnehmen. Entsprechend einer vorteilhaften Ausgestaltung der Erfindung, ist der Betrag des Linearisierungswinkels |α|=45°. Der Linearisierungswinkel α lässt sich beliebig einstellen, und wird nur durch die Anordnung der Magnetisierungsachse des Magnetisierungselements gegenüber der Stromflussachse durch das AMR-Widerstandselement definiert. Durch eine Einstellung von 45° wird bezüglich der AMR-Widerstandskennlinie eine perfekte Linearisierung erreicht, so dass unmittelbar aus der Widerstandsänderung der Betrag des externen Magnetfeldes nachweisbar ist, insbesondere sofern *H*ₑ<*H*₀ gilt. Somit wird die Auswerteelektronik vereinfacht und eine erhöhte Messgenauigkeit erreicht.

Grundsätzlich genügt ein einzelnes Widerstandselement zur Messung einer Magnetfeldvektorkomponente. Entsprechend einer vorteilhaften Weiterbildung kann jede Widerstandseinrichtung eine Reihenschaltung von mehr als 10 AMR-Widerstandselementen umfassen, die bevorzugt entlang einer oder mehrerer paralleler geradliniger Reihen auf dem Chipsubstrat angeordnet sind. Die Magnetisierungsachse der Magnetisierungselemente kann parallel oder senkrecht zur Längserstreckung der Widerstandsreinrichtung ausgerichtet sein. Die Anordnung von zehn oder mehr AMR-Widerstandselementen resultiert in einem vergrößerten AMR-Widerstandswert, so dass ein Stromverbrauch verringert und somit elektrische Verluste gesenkt werden. Die Widerstandselemente sind bevorzugt in einer geradlinigen Reihe angeordnet, wobei mehrere parallele Reihen in elektrischer Reihenschaltung geschaltet werden können, um eine einzelne Widerstandseinrichtung auszubilden. Hierdurch wird eine hohe Packungsdichte erreicht. Jedes einzelne Widerstandselement kann bevorzugt einen Widerstandswert von 5Ω bis 50 Ω aufweisen. Somit ergibt eine Reihenschaltung einen Widerstandswert von mindestens 50 Ω, der typischerweise mehrere 100Ω bis einigen kΩ annehmen kann. Hierdurch kann ein geringer Messstrom und somit eine geringer Energieverbrauch der Vorrichtung erzielt werden.

Die Magnetisierungsachse der Magnetisierungselemente ist bevorzugt parallel, senkrecht oder 45° zur Längserstreckung der in Reihe angeordneten AMR-Widerstandselemente ausgerichtet. Dementsprechend sind die Kontaktierungsstellen und die Form der Leitungsstreifen derart angeordnet und gestaltet, dass der Strom im Winkel α gegenüber der Vormagnetisierung *M*₀ des Widerstandselements fließt. Dabei können die Magnetisierungselemente, die auf der Widerstandseinrichtung angeordnet sind, für alle Widerstandselemente gleichartig ausgerichtet sein. Hierdurch lässt sich ein einzelner Widerstand bzw. eine Widerstandseinrichtung bereitstellen, die auf einem Chipsubstrat in kompakter, platzsparender Weise angeordnet ist.

Entsprechend einer vorteilhaften Weiterbildung kann ein Widerstandselement plättchenförmig ausgebildet sein und eine symmetrische Grundfläche aufweisen, insbesondere eine Grundfläche eines regelmäßigen Polygons, eines Kreises oder einer Ellipse. Durch die plättchenförmige Ausgestaltung, bei der eine geringe Dicke gegenüber Länge und Breite des Widerstandselements gegeben ist, und eine symmetrische Grundfläche kann eine Anordnung einer Vielzahl von Widerstandseinrichtungen auf einem Chipsubstrat ermöglicht werden, wobei die effektive Fläche des Chipsubstrats optimal ausgenutzt werden kann. So kann auf kleinem Raum eine hochkonzentrierte AMR-Widerstandseinrichtung anordnen werden, die eine hohe Sensitivität aufweist. Durch die Ausbildung des Widerstandselements mit einer symmetrischen Grundfläche wird die Stromflussrichtung lediglich durch den Kontaktpunkt und durch die Form der Leitungsstreifen, die das Widerstandselement kontaktieren, vorgegeben. Eine Symmetrie des Widerstandselements bezüglich der Kontaktpunkte bzw. Kontaktbereiche und gegenüber dem Magnetisierungsvektors des Magnetisierungselements hat einerseits den Vorteil, dass eine homogene Stromverteilung des Messstroms *I*_{S} durch das Widerstandselement erreicht, andererseits eine gleichmäßige Vormagnetisierung *M*₀ innerhalb des Widerstandselements gegeben wird. Hierdurch ist die Stromflussrichtung und die Magnetfelddurchflutung durch das AMR-Widerstandselement und somit der Linearisierungswinkel α exakt definiert.

Entsprechend einer vorteilhaften Weiterbildung kann jedem Widerstandselement der Widerstandseinrichtung ein Permanentmagnetisierungselement zugeordnet sein, wobei ein Magnetfluss des Magnetisierungselements des Widerstandselements zumindest teilweise durchsetzt. Ein Permanentmagnetisierungselement besteht vorzugsweise aus einem ferromagnetischen Material wie Eisen, Kobalt, Nickel oder Ferrit, oder einer Legierung davon, bspw. CoPtCr oder Seltenen-Erden-Verbindungen wie CoSm oder NdFeB, die ein statisches Magnetfeld mit einem Nord- und einem Südpol erzeugen. An den beiden Polenden treten magnetische Feldlinien aus und werden durch ein äußeres Streufeld wieder geschlossen. Im Bereich dieses Streufelds ist das Widerstandselement derart angeordnet, dass das Streufeld in dem Linearisierungswinkel α gegenüber der Stromflussrichtung durch das Widerstandselement vom Nordpol zum Südpol verläuft. Jedem Widerstandselement ist in dieser Ausführung ein einzelnes Permanentmagnetisierungselements, d.h. ein Elementarmagnet zugeordnet. Hierbei bietet das Paar von Widerstandselement und Permanentmagnetisierungselement die kleinstmögliche Einheit einer Widerstandseinrichtung, die in der Magnetfeldsensorvorrichtung zusammengefasst sind.

Bei der oben genannten Ausführungsform ist es insbesondere vorteilhaft, dass das Magnetisierungselement das Widerstandselement vollflächig überdeckt, so dass das Streufeld in großen Bereichen das AMR-Widerstandselement durchsetzt. Somit wird eine gute Vormagnetisierung des AMR-Widerstandselements durch das Vormagnetisierungsfeld *H*₀ erreicht.

Alternativ zu den oben genannten Ausführungsformen kann es vorteilhaft sein, das dem Widerstandselement der Widerstandseinrichtung zwei entlang einer gemeinsamen Magnetisierungsachse ausgerichtete Permanentmagnetisierungselemente zugeordnet sind, wobei ein Magnetfluss vom Nordpol eines Magnetisierungselements zum Südpol des benachbarten Magnetisierungselements das Widerstandselement zumindest teilweise durchsetzt. Somit wird in dieser Ausführungsform vorgeschlagen, dass zwei oder mehrere Magnetisierungselemente in Reihe angeordnet sind, wobei ein Magnetfluss vom jeweiligen Nordpol des einen zum Südpol des jeweils benachbarten Magnetisierungselements erfolgt. In diesem Magnetisierungsfluss ist das Permanentmagnetisierungselement derart angeordnet, so dass es von dem Streufluss zwischen den beiden Magnetisierungselementen durchsetzt wird. Hierbei ist keine 1:1-Zuordnung eines einzelnen Magnetisierungselements zu einem Widerstandselement gegeben, sondern jeweils ein Widerstandselement ist dem Zwischenraum zweier Magnetisierungselemente zugeordnet. Somit überdecken sich Magnetisierungselemente und Widerstandselemente nicht, sondern sind versetzt zueinander angeordnet.

Bei dem vorgenannten Ausführungsbeispiel kann es weiterhin vorteilhaft sein, dass das Widerstandselement zwischen den Endbereichen der beiden Magnetisierungselemente angeordnet ist, wobei bevorzugt deren zuweisende Endbereiche das Widerstandselement zumindest abschnittsweise entlang seines Umfangs formkomplementär umschließen. Es wird somit vorteilhaft vorgeschlagen, dass der Endbereich jedes Magnetisierungselement eine derartigen Umfangslinie aufweist, die formkomplementär den Umfang des Widerstandselements umschließt, so dass ein ungestörter Magnetfluss vom Nordpol des einen Magnetisierungselements durch das AMR-Widerstandselement hindurch zum benachbarten Südpol des zweiten Magnetisierungselements erfolgen kann. Somit ergeben sich geringe Streufeldverluste und es kann ein homogenes Vormagnetisierungsfeld *H*₀ erreicht werden.

Gemäß einer weiteren vorteilhaften Ausführungsform der Erfindung kann die Schichtdicke des Widerstandselements und des Magnetisierungselements maximal 10 µm, bevorzugt <1 µm, insbesondere <50 nm betragen, wobei insbesondere die Schichtdicke des Magnetisierungselements nicht mehr als das zehnfache der Schichtdicke des Widerstandselements beträgt. Durch die Höhe der Schichtdicken, die zumindest kleiner als 10 µm, bevorzugt <1 µm, betragen, wird sichergestellt, dass ein kompakter Chipaufbau der AMR-Magnetfeldsensorvorrichtung erreicht wird, wobei keine makroskopischen Magnetfeldspulen oder dergleichen eingesetzt werden müssen. Die Permanentmagnetelemente wie die AMR-Widerstandsstreifen befinden sich auf der gleichen oder auf verschiedenen Ebenen innerhalb eines Chipsubstrats und können in einem kompakten Chipaufbau integriert sein.

Entsprechend einer weiteren vorteilhaften Ausführungsform der Erfindung können zumindest zwei, insbesondere mehrere Widerstandseinrichtungen in einer Vorrichtung umfasst sein, wobei jede Widerstandseinrichtung eine Vielzahl von parallelen geradlinigen Reihen angeordneter Widerstandselementen umfasst und die Reihen zweier Widerstandseinrichtungen interdigital ineinandergreifend angeordnet sind, wobei bevorzugt die Linearisierungswinkel der interdigital angeordneten Widerstandseinrichtungen um 90° versetzt zueinander sind, und wobei die Widerstandseinrichtungen insbesondere in Form einer Halb- oder Vollbrücke verschaltet sind. In dieser Ausführungsform wird eine Magnetfeldsensorvorrichtung vorgeschlagen, die zwei oder mehrere, bevorzugt vier Widerstandseinrichtungen, d.h. einzelne separat kontaktierbare AMR-Messwiderstände umfasst, die kompakt zueinander auf dem Chipsubstrat verschachtelt angeordnet sind. Jede Widerstandseinrichtung besteht aus einer elektrischen Reihenschaltung mehrerer parallelen und in geradlinigen Reihen angeordneten Widerstandselementen, und die Reihen der Widerstandselementen zugehöriger Widerstandseinrichtungen greifen interdigital in Reihen einer benachbarten Widerstandseinrichtung ineinander, um ein kompaktes Design zu erreichen. Dadurch, dass die Reihen von verschiedenen Widerstandseinrichtungen verschachtelt zueinander angeordnet sind, kann prozesstechnisch ein gleichartiges Verhalten der in einer Halb- oder Vollbrücke zusammengeschalteten Widerstandseinrichtungen erreicht werden, so dass ein gleichartiges Widerstandsverhalten der in einer Messbrückenschaltung miteinander verknüpften Widerständen, d.h. Widerstandseinrichtungen gewährleistet werden ist.

Entsprechend einer vorteilhaften Weiterbildung der Erfindung kann auf dem Chipsubstrat in einer unteren Layerebene die Magnetisierungselemente, darauf aufbauend ein die AMR-Widerstandselemente umfasster Layer und darauf aufbauend ein die Kontaktierungsstreifen umfasster Layer angeordnet sein. Dieser Aufbau schlägt vor, dass auf dem Chipsubstrat, das beispielsweise noch mit einer Isolationsschicht beaufschlagt ist, zunächst die Magnetisierungselemente aus einem permanentmagnetischen Material, z.B. CoPtCr angeordnet werden. Darauf aufbauend werden in einer daraufliegenden Schicht die Widerstandselemente derart angeordnet, dass eine 1:1-Relation oder eine 1:2-Relation zwischen Widerstandselementen und Magnetisierungselemente hergestellt ist. In der Regel weisen die Magnetisierungselemente eine größere Flächenausdehnung als die Widerstandselemente auf. Anschließend werden die Kontaktierungsstreifen zwischen den AMR-Widerstandselementen so angeordnet und mit diesen elektrisch kontaktiert, dass ein durch die Reihen von Widerstandselementen fließender Strom einen Linearisierungswinkel α gegenüber der Vormagnetisierung *M*₀ der Widerstandselemente aufweist. Ein derartiger Aufbau hat den Vorteil, dass die in ihrer Fläche am größten ausgestalteten Magnetisierungselemente auf einer unteren Ebene, und die kleiner ausgeformten Widerstandselemente bzw. Kontaktierungsstreifen auf höheren Ebenen des Chipsubstrats angeordnet sind, so dass übliche Verfahren zur Herstellung der Magnetfeldsensorvorrichtung eingesetzt werden können.

Ausgehend von der vorgenannten Layerstrukturierung der Magnetfeldsensorvorrichtung kann es vorteilhaft sein, dass zwischen dem Layer der Widerstandselemente und dem Layer der Magnetisierungselemente ein im wesentlichen magnetisch neutraler Zwischenlayer angeordnet ist, wobei der Zwischenlayer aus einem elektrischen Isolator besteht, der verhindert, dass Kurzschlüsse zwischen den Widerstandselementen über die elektrisch leitfähigen Magnetisierungselemente erfolgt. Dieser im Verhältnis sehr dünn gegenüber dem Magnetisierungselementen und Widerstandselementen ausgebildete Layer ist bevorzugt magnetisch neutral, d.h. weist eine Permeabilität µ=1 auf (paramagnetisch), um den Magnetfeldfluss nicht zu stören.

Des Weiteren wird vorgeschlagen, dass eine isolierende Abdeckschicht, auf dem, die Kontaktierungsstreifen umfassenden Layer aufgebracht ist, so dass die Kontaktierungsstreifen zur Chipoberfläche hin durch einen Abdecklayer isoliert sind. Hierdurch wird eine Layerstrukturierung des Chipsubstrats vorgeschlagen, die eine hochkompakte und einfach herzustellende Magnetfeldsensorvorrichtung beschreibt.

Entsprechend einer Weiterbildung des vorgenannten Chipaufbaus kann es vorteilhaft sein, dass in einer oder mehreren weiteren Layerebenen, insbesondere auf einer oberen Layerebene, ein Kompensationsleiter angeordnet ist, der von einem Kompensationsstrom *I*_{C} durchfließbar ist, um ein Kompensationsmagnetfeld rechtwinklig zur Magnetisierungsachse der Vormagnetisierung *M*₀ und somit entgegen der Richtung des zu messenden externen Magnetfelds *H*ₑ zu erzeugen. Durch den Kompensationsstrom *I*_{C} des Kompensationsleiters kann eine zu messende Komponente eines externen Magnetfelds an den magnetfeldempfindlichen Bereichen des Sensors kompensiert werden. So kann beispielsweise ein Kompensationsstrom *I*_{C} durch den Kompensationsleiter fließen, der ein Magnetfeld entgegen der Richtung des zu messenden Magnetfelds *H*ₑ erzeugt, so dass das externe, zu messende Magnetfeld *H*ₑ kompensiert oder in seiner Wirkung abgeschwächt wird, so dass eine hohe Empfindlichkeit, d.h. Linearität zwischen Widerstandskennlinie und äußerem Magnetfeld erreicht werden kann. Durch das Kompensationsmagnetfeld ist es möglich, verschiedene Skalengrößen von Magnetfeldern zu messen, und den Messbereich der Magnetfeldsensorvorrichtung einzustellen bzw. zu kalibrieren. Die Größe des Kompensationsstroms *I*_{C} gibt somit Aufschluss über die Größe des externen Magnetfeldes. Der Kompensationsleiter ist in Richtung der Vormagnetisierung *M*₀ am Ort des Widerstandselements ausgerichtet und die Richtung des Stromflusses des Kompensationsstroms *I*_{C} gibt Auskunft über die Richtung des externen Magnetfeldes *H*ₑ.

In einem nebengeordneten Aspekt wird ein Kompasssystem vorgeschlagen, das ein, zwei oder drei zueinander abgewinkelt angeordnete, bevorzugt 90° zueinander angeordnete Magnetfeldsensorvorrichtungen für eine ein-, zwei- oder dreidimensionale Messung eines Magnetfeldes vornehmen kann, wobei insbesondere in einer elektronischen Baueinheit eine Erfassung der Richtungsstärke eines Magnetfels, insbesondere des Erdmagnetfelds mit Hilfe einer oben dargestellten Magnetfeldsensorvorrichtung vorgenommen werden kann. Derartige Kompasssysteme finden sich in diversen Anwendungen und Geräten wie beispielsweise Navigationssystemen, Smartphones, Tablet-Computern oder anderen Anwendungen, in denen eine Richtung eines Magnetfelds, insbesondere des Erdmagnetfelds dargestellt werden soll. Ein derartiges Kompasssystem nutzt, ausgerüstet mit der oben genannten Magnetfeldsensorvorrichtung, deren Vorteile aus, und weist insbesondere einen verringerten Stromverbrauch, eine höhere Lebensdauer und geringere Bauteilkosten auf.

Weiterhin wird in einem nebengeordneten Aspekt ein Strommesssystem vorgeschlagen, das mindestens eine Vorrichtung nach den vorgenannten Ansprüchen umfasst, um eine Stromstärke eines oder mehrerer Leiter zu bestimmen. Ein stromdurchflossener Leiter erzeugt ein ihn umgebendes Magnetfeld, wobei durch Messung der Stärke des den Leiter umgebenden Magnetfelds auf den Strom, der durch den Leiter fließt, berührungslos zurückgeschlossen werden kann. Derartige Strommesssysteme werden als transportable Systeme, aber auch stationär zur Überwachung des Stromflusses innerhalb von Maschinen oder Anlagen, beispielsweise Stromverteilungsanlagen vielfältig eingesetzt. Die vorgeschlagene passive Magnetfeldsensorvorrichtung weist außer den Anschlüssen für den Messstrom durch die AMR-Widerstandseinrichtungen und eventuell Stromanschlüsse für Kompensationsleiter keine weiteren Anschlüsse, insbesondere keine Anschlüsse für einen Flipstromleiter auf, so dass durch eine relativ einfache Auswerteelektronik eine berührungslose Strommessung vorgenommen werden kann. Das Strommesssystem kann eine Vielzahl derartiger Messvorrichtungen umfassen, um eine hochgenaue Strommessung vornehmen zu können.

### ZEICHNUNGEN

Weitere Vorteile ergeben sich aus der vorliegenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- **Fig.1**: ein Widerstandskennlinie eines herkömmlichen AMR-Widerstandselementes bezüglich eines externen Magnetfelds *H*ₑ;
- **Fig. 2**: Widerstandskennlinien eines aus dem Stand der Technik bekannten AMR-Widerstandsstreifens mit Barberpolestrukturen;
- **Fig. 3**: ein erstes Ausführungsbeispiel einer Widerstandseinrichtung in Draufsicht und in einer Layerschnittdarstellung;
- **Fig. 4**: ein weiteres Ausführungsbeispiel einer Magnetfeldsensoreinrchtung mit Kompensationsleitern mit Layerschnittdarstellung;
- **Fig. 5**: eine Widerstandskennlinie eines Ausführungsbeispiels einer AMR-Widerstandsvorrichtung;
- **Fig. 6**: eine Ausführungsform einer Widerstandseinrichtung gemäß der Erfindung;
- **Fig. 7**: weitere Ausführungsformen einer Widerstandseinrichtung gemäß der Erfindung;
- **Fig. 8**: eine Ausführungsform einer Widerstandseinrichtung gemäß der Erfindung;
- **Fig. 9**: ein Chiplayout eines Ausführungsbeispiels einer AMR-Widerstandsvorrichtung;
- **Fig. 10**: verschiedene Ausführungsbeispiele von Magnetfeldsensoreinrichtungen, wobei AMR-Widerstandselement und Magnetisierungselement in verschiedenen Variationen zueinander angeordnet sein können.

In den Figuren sind gleichartige Elemente mit gleichartigen Bezugszeichen beziffert.

In der Fig. 1 ist eine Widerstandskennlinie in Abhängigkeit eines Magnetfelds *M(H)* gegenüber der Richtung eines Messstromflusses *I*_{S} durch einen AMR-Widerstandsstreifen 102 einer Magnetfeldsensorvorrichtung 100 dargestellt. Die Widerstandskennlinie *R(M)* bestimmt sich durch die Formel *R* =*R*_{⊥} + (*R*₌ - R_{⊥})cos²(Θ), wobei θ der Winkel zwischen Stromflussrichtung *I*_{S} und einem Gesamtmagnetfeld *M(H)* darstellt. Das Gesamtmagnetfeld *M(H)* setzt sich aus einem Magnetfeld einer inneren Vormagnetisierung *M*₀ und einem externen, zu messenden Magnetfeld *H*ₑ zusammen. Man erkennt, dass bei kleinen Magnetfeldern *H*ₑ *< M*₀ nur eine geringe Änderung des Widerstands *R* bei Änderung des externen Magnetfelds *H*ₑ auftritt. Somit ist eine derartige Konfiguration nachteilig, da die Sensitivität für kleine Magnetfelder relativ gering ist, da die Widerstandskennlinie in diesem Bereich nur eine geringe Steigung aufweist.

In der Fig. 2, die eine AMR-Widerstandsvorrichtung 100 nach dem Stand der Technik darstellt, bei dem ein AMR-Widerstandsstreifen 102 mit um 45° geneigten Barberpolestrukturen 104, d.h. hochleitenden Metallisierungsstreifen wie Gold- oder Kupfermetallisierungen, auf dem AMR-Widerstandsstreifen 102 angeordnet sind, versehen ist. Wie in der Schemaskizze dargestellt, wird durch die AMR-Widerstandsstreifen 104 ein Stromfluss *I*_{S} durch den AMR-Widerstandsstreifen 102 in einer im Wesentlichen 45°-Richtung zur Längsausdehnung des Widerstandsstreifen 102 ausgebildet, so dass der Stromfluss gegenüber einer parallelen inneren Magnetisierung *M*₀ bzw. einem rechtwinkligen externen Magnetfeld *H*ₑ einen Linearisierungswinkel α von 45° annimmt. Dementsprechend wird die in Fig. 1 dargestellte Widerstandskurve verschoben, und zwar in einem Bereich einer steilen Flanke des Kurvenverlaufs, bei dem eine lineare Abhängigkeit von Widerstand zu Magnetfeld auftritt, so dass eine geringe Änderung eines externen Magnetfelds *H*ₑ eine lineare Änderung des Gesamtwiderstands R des Widerstands der AMR-Magnetfeldsensorvorrichtung hervorruft. Mittels einer Linearisierung durch Barberpolestrukturen lässt sich die Sensitivität der Magnetfeldsensorvorrichtung deutlich erhöhen.

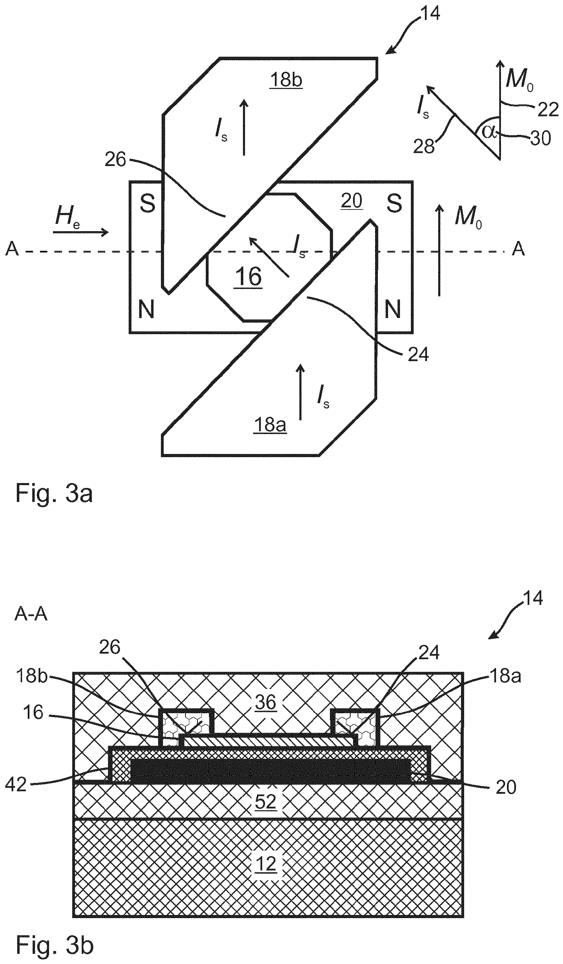

In der Fig. 3 ist ein erstes Ausführungsbeispiel einer Magnetfeldsensoreinrichtung 14 dargestellt. Hierbei besteht das kleinste Element der Widerstandseinrichtung 14 aus einem oktagonförmigen AMR-Widerstandselement 16, der als AMR-Plättchen ausgeformt ist, und der mit zwei Leitungsstreifen 18a und 18b kontaktiert ist. Durch die spezielle Gestaltung der Endbereiche des Widerstandsstreifens 18 und deren Kontaktierungsbereiche 24 und 26, durch die ein Messstrom *I*_{S} in das AMR-Widerstandselement 16 hinein-, und austritt, wird der Stromfluss durch das AMR-Widerstandselement 16 in 45°-Richtung bezüglich des Gesamtstromflusses durch die Leitungsstreifen 18 erzwungen. Ein Permanentmagnetelement 20 ist unterhalb des AMR-Widerstandselements 16 angeordnet und die Vormagnetisierung *M*₀ ist in Richtung des Messstroms *I*_{S} durch die Leitungsstreifen 18 ausgerichtet, d.h. in Längserstreckung einer Reihe benachbarter und durch Leitungsstreifen 18 verbundener Widerstandselemente 16. Der äußere Streufluss vom Nordpol zum Südpol des Magnetisierungselements 20 durchsetzt das Widerstandselement 16 und gibt eine innere Vormagnetisierung *M*₀ vor. Die Größenänderung eines externen und zur Vormagnetisierung rechtwinkligen Magnetfelds *H*ₑ bewirkt, da der Stromfluss *I*ₛ durch das Widerstandselement um 45° zum externen Magnetfeld *H*ₑ abgewinkelt ist, eine linearisierte Veränderung des elektrischen Widerstands durch die Widerstandseinrichtung 14. Somit kann entsprechend zur in Fig. 2 dargestellten Widerstandskennlinie, eine lineare Widerstandsänderung bei einer geringen Änderung des externen Magnetfelds erreicht werden, ohne dass Barberpolestrukturen oder eine externe Magnetisierung durch einen makroskopischen Hilfsmagneten vorgesehen werden müssen.

Fig. 3b zeigt den in Fig. 3a dargestellten Schnitt A-A durch das Chipsubstrat 12 der Widerstandseinrichtung 14. Auf dem Chipsubstrat 12 ist zunächst eine Isolationsschicht 52 angeordnet. Auf dieser Isolationsschicht 52 ist ein permanentmagnetisches Magnetisierungselement 20 angeordnet, das flächenmäßig größer als das scheibenförmige AMR-Widerstandselement 16 ausgebildet ist. Das Permanentmagnetisierungselement 20 ist von einem Zwischenlayer 42, der elektrisch isolierend und magnetisch neutral wirkt, vom AMR-Widerstandselement 16 getrennt. Auf dem Zwischenlayer 42 ist das AMR-Widerstandselement 16 angeordnet, das elektrisch mit den Leitungsstreifen 18 an dem ersten und zweiten Kontaktbereich 24, 26 kontaktiert ist. Durch Form und Position der Kontaktbereiche 24, 26 wird eine Stromflussrichtung durch das AMR-Widerstandselement 16 hervorgerufen, die um einen Linearisierungswinkel α von der Vormagnetisierung *M*₀, die durch das Magnetfeld *H*₀ des Magnetisierungselements 20 hervorgerufen wird, abweicht. Letztlich ist als Oberschicht eine Abdeckschicht 36 ebenfalls aus elektrisch isolierendem und magnetisch neutralem Material aufgebracht, um die Widerstandseinrichtung 14 gegenüber der Umgebung zu kapseln.

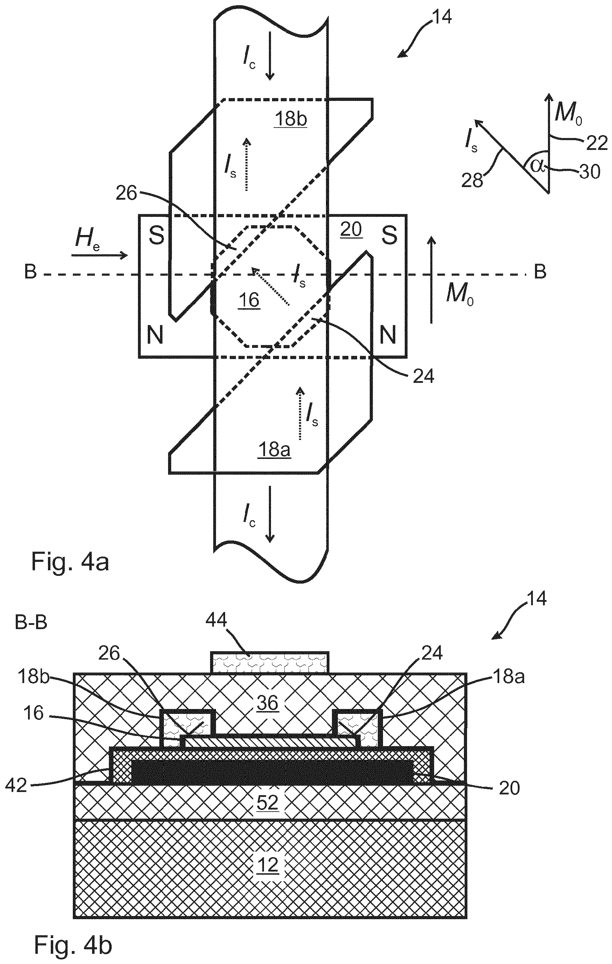

Aufbauend auf der Fig. 3 ist in der Fig. 4 ein weiteres Ausführungsbeispiel einer Magnetfeldsensoreinrichtung 14 dargestellt. Zusätzlich zu der Ausführungsform nach Fig. 3 ist auf der Oberseite oberhalb der Leitungsstreifen 18 ein Kompensationsleiter 44 angeordnet, durch den ein Kompensationsstrom *I*_{C} fließen kann. Durch den Kompensationsstrom *I*_{C} kann ein Kompensationsmagnetfeld erzeugt werden, das dem zu messenden externen Magnetfeld *H*ₑ entgegenwirkt und dieses schwächt. Hierdurch kann eine Kompensation des zu messenden externen Magnetfelds erreicht werden, so dass eine Justierung bzw. Einstellung der Größenordnung des zu messenden Magnetfelds vorgenommen werden kann. Somit kann die Magnetfeldsensoreinrichtung 14 zur Messung unterschiedlich starker Magnetfelder eingesetzt werden. Wird der Widerstand der Widerstandsvorrichtung durch den Kompensationsstrom konstant ausgeregelt, gibt die Grö-βe des Kompensationsstroms *I*_{C} Auskunft über die Stärke des externen Magnetfelds.

In der Fig. 4b ist in einer Schnittdarstellung B-B ein Schichtaufbau des Chipsubstrats der Magnetfeldsensoreinrichtung 14 der Fig. 4a dargestellt, die dem der Fig. 3b ähnelt, und bei der oberhalb der Abdeckschicht 36 ein Kompensationsleiter 44 angeordnet ist. Hierüber kann wiederum eine weitere Abdeckschicht angeordnet sein, um das Chiplayout gegenüber äußeren Umwelteinflüssen zu kapseln. Die in den Querschnittfiguren 3b und 4b dargestellten Grö-ßenverhältnisse der Layerschichten sind nicht maßstabsgetreu, die Dimensionen sind lediglich zu Darstellungszwecken anschaulich gewählt.

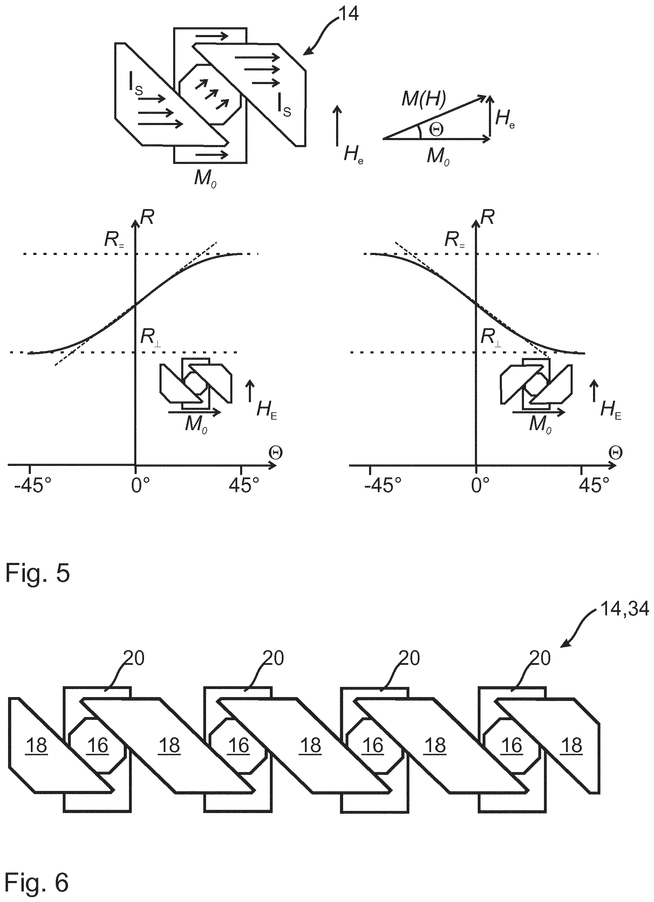

Die Fig. 5 zeigt entsprechend zur Fig.1 und 2 die Widerstandskennlinie für eine Ausführungsform einer Magnetfeldsensoreinrichtung 14, wobei der Widerstand sich linear zu einer Änderung eines externen Magnetfelds *H*ₑ ändern lässt. Je nach Richtung des Stromflusses *I*_{S} durch das AMR-Widerstandselement 14 gegenüber dem externen Magnetfeld *H*ₑ erhält man eine positive bzw. negative Steigung der Widerstandskennlinie *R*.

In der Fig. 6 ist eine lineare Anordnung einer Reihe von AMR-Widerstandselementen 16 dargestellt, die zu einer Widerstandseinrichtung 14 zusammengeschaltet sind. Jedem Widerstandselement 16 ist ein Magnetisierungselement 20 zugeordnet und die Leitungsstreifen 18 kontaktieren die Widerstandselemente 14 derart, dass ein Stromfluss *I*_{S} in einem Linearisierungswinkel α von ca. 45° gegenüber der Vormagnetisierung *M*₀ des Widerstandselements 16 erfolgt. Je höher die Anzahl der AMR-Widerstandselemente 14, umso größer ist der Gesamtwiderstand und die Widerstandsänderung gegenüber einem externen Magnetfeld *H*ₑ. Durch Anordnung einer Vielzahl von Widerstandselementen 16 in einer Widerstandseinrichtung 14 wird der Stromverbrauch herabgesetzt, so dass insbesondere batterie- oder akkubetriebene Geräte eine längere Batterielebensdauer aufweisen.

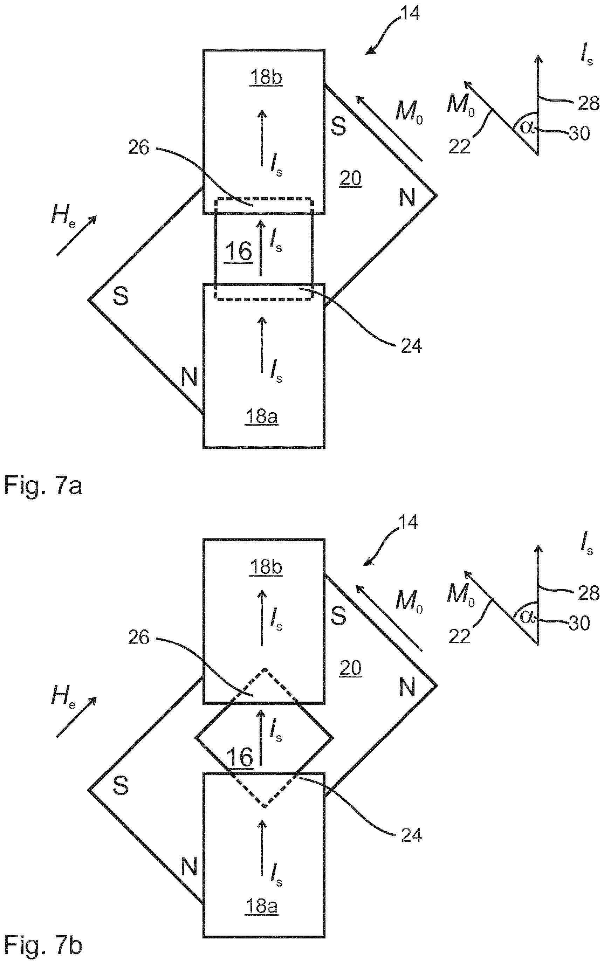

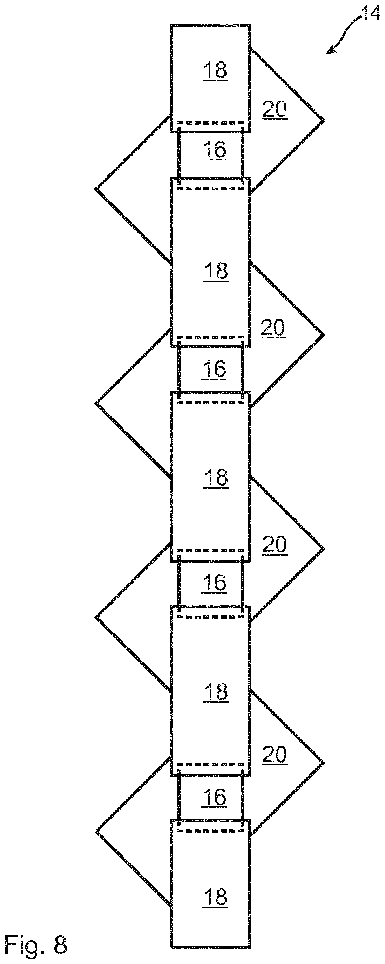

In den Figs. 7a und 7b sind entsprechend der Fig. 3 weitere Ausführungsbeispiele von Widerstandseinrichtungen 14 dargestellt, die vereinfacht aus einem Widerstandselement 16, einem Magnetisierungselement 20 und zwei Leitungsstreifen 18, 18b bestehen. Die Fig. 8 zeigt eine Reihenschaltung von vier Einrichtungen 14 nach Fig. 7a, die auf einem Chipsubstrat 12 angeordnet sein können. In der Regel umfasst eine Widerstandseinrichtung 14 mehrere, insbesondere mehr als zehn elektrisch in Reihe geschaltete Ausführungen nach Fig. 7. Im Unterschied zur Ausführungsform nach der Fig. 3 ist das AMR-Widerstandselement 16 quadratisch ausgebildet, und ist, wie in Fig. 7a dargestellt, um 45° gegenüber dem rechteckförmig ausgestaltetem Magnetisierungselement 20 gedreht auf diesem angeordnet sein. Es kann auch, wie in Fig. 7b dargestellt, parallel zu den Seitenkanten des Magnetisierungselements 20 ausgerichtet sein. Die Leitungsstreifen 18 weisen eine im Wesentlichen rechteckförmige Gestalt auf, und überdecken im überlappenden Kontaktbereichen 24, 26 das Widerstandselement 14. Das Magnetisierungselement 20 überdeckt vollflächig das Widerstandselement 14. Die Magnetisierungsachse 22 ist in diesen Konfigurationen um 45° gegenüber dem geradlinigen Stromflussvektor 28, der parallel und gleichsinnig in den Leitungsstreifen 18a, 18b und dem Widerstandselement 14 ausgerichtet ist, abgewinkelt. Dementsprechend kann eine derartige Ausführungsform eine externe Magnetfeldkomponente *H*ₑ messen, die um 45° gegenüber der Längserstreckung der in Fig. 8 dargestellten Magnetfeldwiderstandseinrichtungen 14 abgewinkelt ist. Somit sind Reihen derartiger Widerstandseinrichtungen 14 auf einem Chipsubstrat 12 um den Linearisierungswinkel α gegenüber dem zu messenden externen Magnetfeld *H*ₑ ausgerichtet. Jede der Anordnungen nach Fig. 3, 7a oder 7b weist eine Symmetrie gegenüber dem Stromvektor 28 und dem Magnetisierungsvektor 22 auf, so dass eine homogene magnetische Vormagnetisierung und Stromverteilung im Widerstandselement 14 gegeben ist.

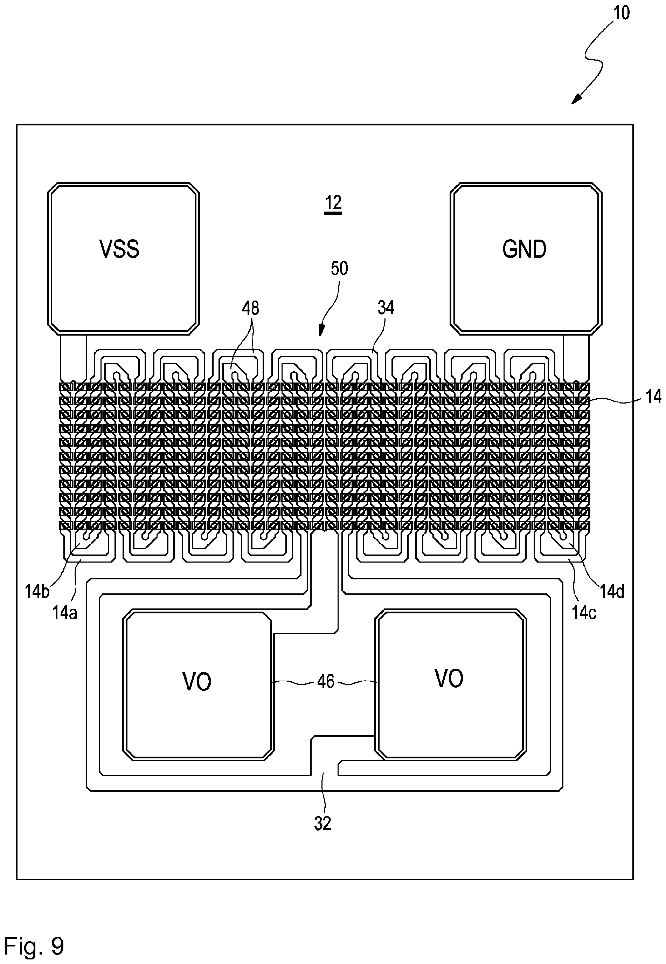

Fig. 9 zeigt ein Ausführungsbeispiel eines Layouts einer Magnetfeldsensorvorrichtung 10, bei dem vier Widerstandseinrichtungen 14, die aus mehreren in Reihe angeordneten Widerstandselementen 16 zusammengesetzt sind, besteht. Die einzelnen Reihen der Widerstandselemente 16 zweier Widerstandseinrichtungen 14 greifen interdigital ineinander, um eine Homogenisierung der Widerstände zu erreichen. Die einzelnen Reihen der Widerstandseinrichtung 14 sind entsprechend des in den Figs. 6 gezeigten Ausführungsbeispiels aufgebaut. Auf dem Chiplayout sind vier Widerstandseinrichtungen 14a bis 14d miteinander in einer Wheatstone-Messbrücke verschaltet, wobei die beiden Zweige der Wheatstone-Messbrücke mit den Kontakten VSS bzw. GND unter Spannung gesetzt werden können und die Mittelabgriffe V0 der beiden Zweige als Messpatches V0 herausgeführt sind. Mit Hilfe der in der Fig. 7 dargestellten Magnetfeldsensorvorrichtung 10 kann eine Komponente eines externen Magnetfelds *H*ₑ gemessen werden. Zu Bestimmung eines dreidimensionalen Magnetfelds, beispielsweise für eine Magnetfeldkompassvorrichtung, werden drei um jeweils 90° zueinander versetzte Magnetfeldsensorvorrichtungen 10 benötigt, die jeweils um 90° versetzt zueinander angeordnet werden. Auf einem Chipsubstrat können zwei um 90° versetzte Magnetfeldsensorvorrichtungen zur Messung des Magnetfeldes in zwei Dimensionen angeordnet werden.

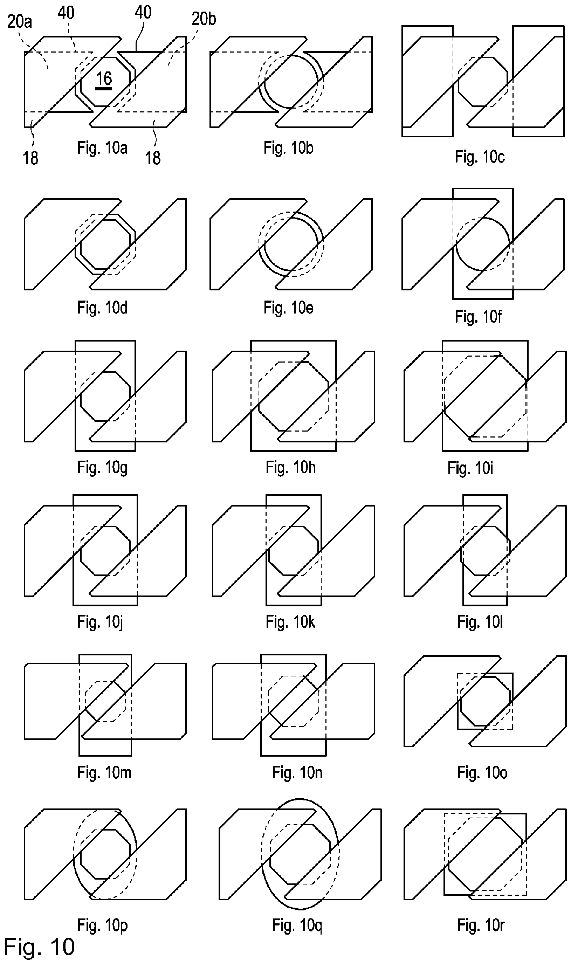

Schließlich zeigt die Fig. 10 achtzehn verschiedene Ausführungsbeispiele, wie Widerstandselemente 16 gegenüber Leitungsstreifen 18 und Magnetisierungselementen 20 angeordnet werden können. In den ersten drei Ausführungsbeispielen 10a bis 10c sind jeweils einem Widerstandselement 16, das oktagonförmig bzw. rund ausgeformt sein kann, zwei Magnetisierungselemente 20a, 20b zugeordnet. Dabei sind die jeweiligen Enden der Magnetisierungselemente 20a, 20b formkomplementär zu den Umfangsbereichen der Widerstandselemente 16 ausgeformt, so dass ein möglichst geringer Streufluss und eine möglichst gute Durchdringung des Widerstandselements durch die Magnetfelder vom Nordpol des einen zum Südpol des anderen Magnetisierungselements erfolgen kann.

In den Figs. 10d und 10e ist das Magnetisierungselement 20 formidentisch nur geringfügig vergrößert gegenüber der Form des Widerstandselements 16 ausgeformt, so dass eine geringe Baugröße und eine geringe Menge von Magnetisierungswerkstoff eingesetzt werden muss.

Die Figs. 10f bis 10o und 10r zeigen eine 1:1 Beziehung eines Widerstandselements 16 mit einem Magnetisierungselement 20, wobei das Magnetisierungselement 20 grundsätzlich rechteckförmig mit verschiedenen Überdeckungsgrö-ßen und das Widerstandselement rund bzw. oktagonförmig in verschiedenen Größen ausgeformt sein kann.

Schließlich zeigen die Figs. 10p bis 10q Magnetisierungselemente 20, die elliptisch ausgeformt sind, und deren Magnetisierungsfeld parallel bzw. rechtwinklig zur Stromflussrichtung des Messstroms durch eine Reihe von AMR-Widerstandselementen 16ausgerichtet sein kann. Beliebige weitere Variationen und Kombinationen dieser Ausführungsbeispiele sind denkbar.

Das Chipsubstrat ist bevorzugt ein Substrat auf Basis von SiO2. Die Zwischenschicht kann ein SiN-Material (Silizium-Mononitride) mit einer Schichtdicke zwischen 10 nm bis 1000 nm sein. Die Dicke der Permanentmagnetelemente kann 10 nm bis 100 nm betragen, die Permanentmagnetelemente können aus einer CoPtCr-Verbindung (Kobalt-Platin-Chrom-Verbindung) bestehen. Als Zwischenmaterial kann des Weiteren eine AlOx-Verbindung in Frage kommen. Bevorzugt weisen die magnetoresistiven AMR-Strukturen eine symmetrische Form auf, und die Permanentmagnetelemente überdecken diese flächig, bzw. umfassen diese entlang eines Umfangsabschnitts, so dass ein magnetisches Streufeld der Permanentmagnetelemente die AMR-Widerstandselemente durchsetzt.

### Bezugszeichenliste

- 10: Magnetfeldsensorvorrichtung
- 12: Chipsubstrat
- 14: AMR-Widerstandseinrichtung
- 16: Widerstandselement
- 18: Leitungsstreifen
- 20: permanentmagnetisches Magnetisierungselement
- 22: Magnetisierungsachse
- 24: Erster Kontaktbereich
- 26: Zweiter Kontaktbereich
- 28: Stromrichtungsachse
- 30: Linearisierungswinkel
- 32: Reihenschaltung
- 34: Reihe von Widerstandselementen
- 36: Abdeckschicht

- 40: Endbereiche des Permanentmagnetisierungselements
- 42: Zwischenlayer
- 44: Kompensationsleiter
- 46: Anschlusspad
- 48: Interdigitalanordnung
- 50: Vollbrücke
- 52: Isolationsschicht

- 100: Magnetfeldsensorvorrichtung nach dem Stand der Technik
- 102: AMR-Widerstandsstreifen
- 104: Barberpolstruktur

## Patentansprüche

1. Magnetfeldsensorvorrichtung (10) zur Messung genau einer Magnetfeldvektorkomponente *H*ₑ, umfassend zumindest eine auf einem Chipsubstrat (12) angeordnete anisotrope magnetoresistive Widerstandseinrichtung, AMR-Widerstandseinrichtung (14), wobei die Widerstandseinrichtung (14) eine Mehrzahl von magnetoresistiven AMR-Widerstandselementen (16) umfasst, die durch elektrische Leitungsstreifen (18) in Reihe kontaktiert sind, **dadurch gekennzeichnet, dass** jedem Widerstandselement (16) zumindest ein permanentmagnetisches Magnetisierungselement (20) mit einer Magnetisierungsachse (22) derart zugeordnet ist, so dass das Widerstandselement (16) von einem Vormagnetisierungsfeld *H*₀ des Magnetisierungselements (20) in Richtung der Magnetisierungsachse (22) durchsetzt wird, wobei ein durch das Widerstandselement (16) fließender Messstrom *I*_{S} von einem Kontaktbereich (24) zwischen einem ersten Leitungsstreifen (18a) und dem Widerstandselement (16) zu einem Kontaktbereich (26) zwischen dem Widerstandselement (16) und einem zweiten Leitungsstreifen (18b) eine mittlere Stromrichtungsachse (28) aufweist, die in einem vordefinierbaren Linearisierungswinkel α>0° und α<90° (30) zur Magnetisierungsachse (22) steht.

2. Magnetfeldsensorvorrichtung (10) nach Anspruch 1, **dadurch gekennzeichnet, dass** der Betrag des Linearisierungswinkels |α|=45° (30) beträgt.

3. Magnetfeldsensorvorrichtung (10) nach Anspruch 1 oder 2, **dadurch gekennzeichnet, dass** jede Widerstandseinrichtung (14) eine Reihenschaltung (32) von mehr als zehn AMR-Widerstandselementen (16) umfasst, die bevorzugt entlang einer oder mehrerer geradliniger Reihen (34) auf dem Chipsubstrat (12) angeordnet sind, wobei die Magnetisierungsachse (22) der Magnetisierungselemente (20) bevorzugt parallel, senkrecht oder 45° zur Längserstreckung der Widerstandseinrichtung (14) ausgerichtet ist.

4. Magnetfeldsensorvorrichtung (10) nach einem der vorhergehenden Ansprüche, **dadurch gekennzeichnet, dass** das Widerstandselement (16) plättchenförmig ausgebildet ist und eine symmetrische Grundfläche aufweist, insbesondere eine Grundfläche eines regelmäßigen Polygons, eines Kreises oder einer Ellipse.

5. Magnetfeldsensorvorrichtung (10) nach einem der vorhergehenden Ansprüche, **dadurch gekennzeichnet, dass** jedem Widerstandselement (16) der Widerstandseinrichtung (14) ein Permanentmagnetisierungselement (20) zugeordnet ist, wobei ein Magnetfluss des Magnetisierungselements (20) das Widerstandselement (16) zumindest teilweise durchsetzt.

6. Magnetfeldsensorvorrichtung (10) nach Anspruch 5, **dadurch gekennzeichnet, dass** das Magnetisierungselement (20) das Widerstandselement (16) vollflächig überdeckt.

7. Magnetfeldsensorvorrichtung (10) nach einem der Ansprüche 1 bis 4, **dadurch gekennzeichnet, dass** jedem Widerstandselement (16) der Widerstandseinrichtung (14) zwei entlang einer gemeinsamen Magnetisierungsachse (22) ausgerichtete Permanentmagnetisierungselemente (20) zugeordnet sind, wobei ein Magnetfluss vom Nordpol eines Magnetisierungselements (20a) zum Südpol des benachbarten Magnetisierungselements (20b) das Widerstandselement (16) zumindest teilweise durchsetzt.

8. Magnetfeldsensorvorrichtung (10) nach Anspruch 7, **dadurch gekennzeichnet, dass** das Widerstandselement (16) zwischen den Endbereichen (40) der Magnetisierungselemente (20) angeordnet ist, wobei bevorzugt deren zuweisenden Endbereiche (40) das Widerstandselement (16) zumindest abschnittsweise entlang seines Umfangs formkomplementär umschließen.

9. Magnetfeldsensorvorrichtung (10) nach einem der vorangehenden Ansprüche, **dadurch gekennzeichnet, dass** die Schichtdicke des Widerstandselements (16) und des Magnetisierungselements (20) maximal 10 µm, bevorzugt kleiner 1 µm betragen, wobei insbesondere die Schichtdicke des Magnetisierungselements (20) nicht mehr als das Zehnfache der Schichtdicke des Widerstandselements (16) beträgt.

10. Magnetfeldsensorvorrichtung (10) nach einem der vorgenannten Ansprüche, **dadurch gekennzeichnet, dass** zumindest zwei, insbesondere mehrere Widerstandseinrichtungen (14) umfasst sind, wobei jede Widerstandseinrichtung (14) eine Vielzahl von in parallelen geradlinigen Reihen (34) angeordneter Widerstandselementen (16) umfasst, und die Reihen (34) zweier Widerstandseinrichtungen (14) interdigital ineinander greifend angeordnet sind, wobei bevorzugt die Linearisierungswinkel (30) der interdigital angeordneten Widerstandseinrichtungen (14) um 90° versetzt zueinander sind, und wobei die Widerstandseinrichtungen (14) insbesondere in Form einer Halb- oder Vollbrücke verschaltet sind.

11. Magnetfeldsensorvorrichtung (10) nach einem der vorgenannten Ansprüche, **dadurch gekennzeichnet, dass** auf dem Chipsubstrat (12) in einer unteren Layerebene die Magnetisierungselemente (20), darauf aufbauend ein die AMR-Widerstandselemente (16) umfassender Layer (16), und darauf aufbauend ein die Kontaktierungsstreifen (18) umfassender Layer angeordnet sind.

12. Magnetfeldsensorvorrichtung (10) nach Anspruch 11, **dadurch gekennzeichnet, dass** zwischen dem Layer der Widerstandselemente (16) und dem Layer der Magnetisierungselemente (20) ein im Wesentlichen magnetisch neutraler Zwischenlayer (42) angeordnet ist, wobei der Zwischenlayer (42) aus einem elektrischen Isolator besteht und dass eine isolierende Abdeckschicht (36) auf dem die Kontaktierungsstreifen (18) umfassenden Layer aufgebracht ist.

13. Magnetfeldsensorvorrichtung (10) nach einem der vorgenannten Ansprüche, **dadurch gekennzeichnet, dass** in einer oder mehreren weiteren Layerebenen, insbesondere auf einer oberen Layerebene ein Kompensationsleiter (44) angeordnet ist, der von einem Kompensationsstrom *I*_{C} durchfließbar ist, um ein Kompensationsmagnetfeld rechtwinklig zur Magnetisierungsachse (22) der Vormagnetisierung *M*₀ zu erzeugen, so dass eine zu messende Komponente eines externen Magnetfelds an den magnetfeldempfindlichen Bereichen des Sensors kompensierbar ist.

14. Kompasssystem umfassend eine, zwei oder drei gegeneinander abgewinkelt angeordnete, bevorzugt 90° abgewinkelt angeordnete Magnetfeldsensorvorrichtungen (10) nach einem der vorgenannten Ansprüche, die insbesondere in einer elektronischen Baueinheit zur Erfassung der Richtung und Stärke eines Magnetfeldes, insbesondere des Erdmagnetfeldes zusammengefasst sind.

15. Strommesssystem umfassend mindestens eine Magnetfeldsensorvorrichtung (10) nach einem der vorgenannten Ansprüche 1 bis 13, die insbesondere in einer elektronischen Baueinheit zur Messung einer Stromstärke eines oder mehrerer Leiter durch Messung der Stärke des den Leiter umgebenden Magnetfelds zusammengefasst sind.

## Claims

1. Magnetic field sensor apparatus (10) for measuring at least one magnetic field vector component *H*ₑ, comprising at least one anisotropic magnetoresistive resistor device AMR resistor device (14) arranged on a chip substrate (12), where the resistor device (14) comprises a plurality of magnetoresistive AMR resistor elements (16) which are connected in series by electrically conductive strips (18), **characterized in that** at least one permanent magnetic magnetization element (20) with a magnetization axis (22) is assigned to each resistor element (16) in such a way that the resistor element (16) is passed through by an initial magnetization field *H*₀ of the magnetization element (20) in the direction of the magnetization axis (22), where a measurement current *I*_{S} flowing through the resistor element (16) from a contact region (24) between a first conductive strip (18a) and the resistor element (16) to a contact region (26) between the resistor element (16) and a second conductive strip (18b) has a mean current direction axis (28) at a predefined linearization angle α > 0° and α < 90° (30) relative to the magnetization axis (22).

2. Magnetic field sensor apparatus (10) according to claim 1, **characterized in that** the value of the linearization angle is |α| = 45° (30).

3. Magnetic field sensor apparatus (10) according to claim 1 or 2, **characterized in that** each resistor device (14) comprises a series circuit (32) of more than 10 AMR resistor elements (16) which preferably are arranged along one or more straight rows (34) on the chip substrate (12), where the magnetization axis (22) of the magnetization elements (20) is aligned preferably parallel, perpendicular or 45° to the longitudinal extent of the resistor device (14).

4. Magnetic field sensor apparatus (10) according to one of the preceding claims, **characterized in that** the resistor element (16) is formed as a platelet and has a symmetrical footprint, in particular a footprint of a regular polygon, a circle or an ellipse.

5. Magnetic field sensor apparatus (10) according to one of the preceding claims, **characterized in that** a permanent magnetization element (20) is assigned to each resistor element (16) of the resistor device (14), where a magnetic flux of the magnetization element (20) passes at least partly through the resistor element (16).

6. Magnetic field sensor apparatus (10) according to claim 5, **characterized in that** the magnetization element (20) covers the full area of the resistor element (16).

7. Magnetic field sensor apparatus (10) according to one of claims 1 to 4, **characterized in that** two permanent magnetization elements (20) aligned along a common magnetization axis (22) are assigned to each resistor element (16) of the resistor device (14), where a magnetic flux from the north pole of one magnetization element (20a) to the south pole of the adjacent magnetization element (20b) passes at least partly through the resistor element (16).

8. Magnetic field sensor apparatus (10) according to claim 7, **characterized in that** the resistor element (16) is arranged between the end regions (40) of the magnetization elements (20), where the end regions (40) facing towards them preferably enclose the resistor element (16) with a complementary shape along at least a section of its periphery.

9. Magnetic field sensor apparatus (10) according to one of the preceding claims, **characterized in that** the layer thicknesses of the resistor element (16) and of the magnetization element (20) are at most 10 µm, preferably less than 1 µm, where in particular the layer thickness of the magnetization element (20) is not more than 10 times the layer thickness of the resistor element (16).

10. Magnetic field sensor apparatus (10) according to one of the preceding claims, **characterized in that** at least two and in particular several resistor devices (14) are comprised, where each resistor device (14) comprises a plurality of resistor elements (16) arranged in straight and parallel rows, and said rows (34) of two resistor devices (14) are arranged to mesh with one another interdigitally, where the linearization angles (30) of the interdigitally arranged resistor devices (14) are preferably displaced by 90° relative to one another, and where the resistor devices (14) are in particular interconnected in the form of a half-bridge or a full bridge.

11. Magnetic field sensor apparatus (10) according to one of the preceding claims, **characterized in that** the magnetization elements (20) are arranged in a lower planar layer of the chip substrate (12), on top of which a layer comprising the AMR resistor elements (16) is arranged, and on top of that a layer comprising the contacting strips (18) is arranged.

12. Magnetic field sensor apparatus (10) according to claim 11, **characterized in that** an intermediate layer (42) which is essentially magnetically neutral is arranged between the layer of the resistor elements (16) and the layer of the magnetization elements (20), where the intermediate layer (42) consists of an electrical insulator, and **in that** an insulating covering layer (36) is applied to the layer comprising the contacting strips (18).

13. Magnetic field sensor apparatus (10) according to one of the preceding claims, **characterized in that** a compensation conductor (44) is arranged in one or more further planar layers, in particular on an upper planar layer, through which conductor a compensation current *I*_{C} can flow in order to generate a compensating magnetic field perpendicular to the magnetization axis (22) of the initial magnetization *M*₀, so that a component of an external magnetic field to be measured can be compensated at the magnetically sensitive regions of the sensor.

14. Compass system comprising one, two, or three magnetic field sensor apparatuses (10) arranged at angles to one another, preferably at 90°, according to one of the previous claims, which are integrated in particular into an electronic assembly for detecting the direction and strength of a magnetic field, in particular of the Earth's magnetic field.

15. Current measuring system comprising at least one magnetic field sensor apparatus (10) according to one of the above claims 1 to 13, which are integrated in particular into an electronic assembly for measuring a current strength of one or more conductors by measuring the strength of the magnetic field surrounding the conductor.

## Revendications

1. Dispositif à capteur de champ magnétique (10) servant à mesurer exactement une composante vectorielle du champ magnétique *Hₑ*, comprenant au moins un dispositif magnétorésistifmagnéto résistif anisotrope, dit dispositif résistif AMR (14), disposé sur un substrat de puce (12), sachant que le dispositif résistif (14) comprend une multitude d'éléments magnétorésistifs AMR (16) qui sont branchés en série au moyen de bandes conductrices d'électricité (18), **caractérisé en ce qu'**au moins un élément d'aimantation permanente (20) avec un axe d'aimantation (22) est affecté à chaque élément résistif (16) de telle manière que l'élément résistif (16) est traversé par un champ de prémagnétisation *H*₀ de l'élément d'aimantation (20) dans le sens de l'axe d'aimantation (22), sachant qu'un courant de mesure *Iₛ* circulant à travers l'élément résistif (16) présente un axe moyen de sens du courant (28) allant d'une zone de contact (24) entre une première bande conductrice (18a) et l'élément résistif (16) à une zone de contact (26) entre l'élément résistif (16) et une deuxième bande conductrice (18b), ledit axe moyen de sens du courant se situant dans un angle de linéarisation prédéfinissable, tel que α>0° et α<90° (30), par rapport à l'axe d'aimantation (22).

2. Dispositif à capteur de champ magnétique (10) selon la revendication 1, **caractérisé en ce que** la valeur de l'angle de linéarisation est | α |=45° (30).

3. Dispositif à capteur de champ magnétique (10) selon la revendication 1 ou 2, **caractérisé en ce que** chaque dispositif résistif (14) comprend un montage en série (32) de plus de dix éléments résistifs AMR (16) qui sont disposés de préférence le long d'une ou de plusieurs rangées rectilignes (34) sur le substrat de puce (12), sachant que l'axe d'aimantation (22) des éléments d'aimantation (20) est orienté de préférence parallèlement, verticalement ou à 45° par rapport à l'extension longitudinale du dispositif résistif (14).

4. Dispositif à capteur de champ magnétique (10) selon une des revendications précédentes, **caractérisé en ce que** l'élément résistif (16) a la forme d'une lamelle et présente une surface de base symétrique, notamment la surface de base d'un polygone régulier, d'un cercle ou d'une ellipse.

5. Dispositif à capteur de champ magnétique (10) selon une des revendications précédentes, **caractérisé en ce qu'**un élément d'aimantation permanente (20) est affecté à chaque élément résistif (16) du dispositif résistif (14), sachant qu'un flux magnétique de l'élément d'aimantation (20) traverse au moins partiellement l'élément résistif (16).

6. Dispositif à capteur de champ magnétique (10) selon la revendication 5, **caractérisé en ce que** l'élément d'aimantation (20) recouvre l'élément résistif (16) sur toute sa surface.

7. Dispositif à capteur de champ magnétique (10) selon une des revendications 1 à 4, **caractérisé en ce que** deux éléments d'aimantation permanente (20) orientés le long d'un axe d'aimantation commun (22) sont affectés à chaque élément résistif (16) du dispositif résistif (14), sachant qu'un flux magnétique allant du pôle nord d'un élément d'aimantation (20a) au pôle sud d'un élément d'aimantation voisin (20b) traverse au moins partiellement l'élément résistif (16).

8. Dispositif à capteur de champ magnétique (10) selon la revendication 7, **caractérisé en ce que** l'élément résistif (16) est disposé entre les extrémités (40) des éléments d'aimantation (20), sachant que, de préférence, les extrémités (40) orientés vers l'élément résistif (16) entourent celui-ci en épousant sa forme au moins sur une portion le long de sa périphérie.

9. Dispositif à capteur de champ magnétique (10) selon une des revendications précédentes, **caractérisé en ce que** l'épaisseur de couche de l'élément résistif (16) et de l'élément d'aimantation (20) est de 10 µm maximum et de préférence inférieure à 1 µm, sachant que l'épaisseur de couche de l'élément d'aimantation (20) ne doit pas être plus de dix fois plus grande que celle de la couche de l'élément résistif (16).

10. Dispositif à capteur de champ magnétique (10) selon une des revendications précédentes, **caractérisé en ce qu'**il comprend plusieurs, dont au moins deux, dispositifs résistifs (14), sachant que chaque dispositif résistif (14) comprend une multitude d'éléments résistifs (16) disposés sur des rangées rectilignes parallèles (34) et que les rangées (34) de deux dispositifs résistifs (14) sont disposées de manière à s'engager interdigitalement l'une dans l'autre, sachant que les angles de linéarisation (30) des dispositifs résistifs (14) disposés interdigitalement sont décalés de préférence de 90° les uns par rapport aux autres et sachant que les dispositifs résistifs (14) sont connectés notamment sous la forme d'un demi-point ou d'un pont complet.

11. Dispositif à capteur de champ magnétique (10) selon une des revendications précédentes, **caractérisé en ce que** se trouvent sur une couche inférieure du substrat de puce (12) les éléments d'aimantation (20), au-dessus desquels est disposée une couche (16) comprenant les éléments résistifs AMR (16) et au-dessus de laquelle couche se trouve une couche (18) comprenant les bandes de contact (18).

12. Dispositif à capteur de champ magnétique (10) selon la revendication 11, **caractérisé en ce qu'**une couche intermédiaire (42) essentiellement neutre d'un point de vue magnétique est disposée entre la couche des éléments résistifs (16) et la couche des éléments d'aimantation (20), sachant que ladite couche intermédiaire (42) est constituée d'un isolant électrique et qu'un revêtement isolant (36) est appliqué sur la couche comprenant les bandes de contact (18).

13. Dispositif à capteur de champ magnétique (10) selon une des revendications précédentes, **caractérisé en ce qu'**un conducteur de compensation (44) est disposé dans une ou plusieurs des autres couches, notamment dans une couche supérieure, lequel conducteur de compensation peut être traversé par un courant de compensation *I_{c}* pour générer un champ magnétique de compensation perpendiculaire à l'axe d'aimantation (22) de la prémagnétisation *Mₒ* de telle manière qu'une composante à mesurer appartenant à un champ magnétique externe peut être compensée au niveau des zones sensibles au champ magnétique du capteur.

14. Système de boussole comprenant un, deux ou trois dispositifs à capteur de champ magnétique (10) selon une des revendications précédentes disposés en angle les uns par rapport aux autres, et de préférence à un angle de 90°, lesquels dispositifs à capteur de champ magnétique sont regroupés notamment dans une unité électronique servant à déterminer le sens et l'intensité d'un champ magnétique, notamment du champ magnétique terrestre.

15. Système de mesure du courant comprenant au moins un dispositif à capteur de champ magnétique (10) selon une des revendications précédentes 1 à 13, lequel ou lesquels dispositifs à capteur de champ magnétique sont regroupés notamment dans une unité électronique servant à mesurer l'intensité du courant d'un ou de plusieurs conducteurs en mesurant l'intensité du champ magnétique entourant le conducteur.
